# EUROPEAN PATENT SPECIFICATION

(11) **EP 1 118 145 B1**
(45) Date of publication and mention of the grant of the patent: **18.12.2002**
(21) Application number: 99970515.5
(22) Date of filing: 28.09.1999
(51) Int. Cl.: H01S 5/026

(54) **TUNEABLE LASER AND METHOD OF TUNING THE SAME**
ABSTIMMBARER LASER UND VERFAHREN ZU DESSEN ABSTIMMUNG
LASER ACCORDABLE ET PROCEDE POUR ACCORDER CE DERNIER

(30) Priority: 28.09.1998 SE 9803285
(43) Date of publication of application: 25.07.2001
(73) Proprietor: Acreo AB, 164 40 Kista (SE)
(72) Inventor: RIGOLE, Pierre, Jean, S-120 50 Arsta (SE)
(74) Representative: Örtenblad, Bertil Tore
(86) International application number: SE9901715
(87) International publication number: WO00022705

(56) References cited:
- US-A- 4 955 028
- US-A- 5 305 336
- US-A- 5 442 651
- US-A- 5 463 647
- US-A- 5 828 688

## Description

The present invention relates to a tuneable laser and to a method of tuning the same.

Tuneable semiconductor lasers have several different sections through which current is injected. The lasers will typically have three or four sections. The wavelength, power and mode purity of the lasers can be controlled by adjusting the current in the various sections. Mode purity means that the laser shall find itself in an operating point, i.e. in a combination of the three or four injected drive currents, which is characterised by the laser being located far from a combination of drive currents in which so-called mode jumps take place and where lasing of the laser is stable and side mode suppression is high.

Different applications have special requirements with respect to wavelength control. In telecommunications applications one requirement is that once having set the drive current and temperature, the laser shall retain its wavelength with a very high degree of accuracy over a very long period of time. A typical accuracy is 0.1 nanometer while a typical time period is twenty years.

Various types of tuneable lasers are available, such as DBR lasers and GSCR lasers. These laser types are described briefly below.

A common feature of these types of lasers is that they are tuned by injecting current into one or more of the laser sections, whereby the lasers lase at different wavelengths for different combinations of current injection.

One problem with this type of lasers in which the wavelength is given by the set injected currents is that the precision with respect to frequency at an operating point is not equally as high as the precision, e.g., of a type of laser where the monolithic Bragg reflector has been replaced with an external reflector in the form of a sampled fibre grating. A fibre that has been doped with Erbium to obtain amplification and which has been provided with a sampled grating to provide wavelength selected feedback is one example of such a laser. A laser of this nature can be tuned by mechanically stretching or elongating the fibre. With respect to frequency, this provides a precision that could correspond to an S-DBR or a GCSR laser design that has a very long reflector cavity. For instance, the cavity would need to have a length of 4.3 millimetres in order to achieve a precision of 10 GHz. It would be very difficult to produce such cavities with sufficient precision, due to manufacturing difficulties of a technical nature.

One advantage with lasers of this type is that they lase at a very narrow and well-defined frequency. A serious drawback, on the other hand, is that such lasers must be tuned by influencing the grating mechanically.

Current control is highly beneficial for communication purposes. However, it is difficult to control the first mentioned type of laser to lase in a pure mode and with high precision at a given frequency. This difficulty increases with ageing of the laser.

The present invention provides a laser that has the advantages of a laser which includes an external reflector while eliminating those drawbacks associated with such a laser, by virtue of enabling the laser to be tuned by current control instead of by mechanical actuation.

US-A-4 955 028 discloses a tuneable laser according to the preamble of claim 1.

The present invention according to claim 1 thus relates to a tuneable laser that includes a gain section and a tuneable, wavelength selective filter, and is characterised in that a reflection filter in the form of an external reflector is adapted to deliver a number of fixed reflection maxima, wherein each maximum corresponds to a given wavelength and wherein said reflection filter is adapted to coact with said tuneable filter; and in that the laser is constructed to be tuned by current control such as to lase at any one of said wavelengths, by tuning the tuneable filter.

The invention also relates to a method of the kind defined in Claim 12 and having essentially the characteristic features set forth in said Claim.

The invention will now be described in more detail with reference to exemplifying embodiments thereof and also with reference to the accompanying drawings, in which
- Figure 1 illustrates a partially cut-away known DBR laser in perspective;
- Figure 2 is a sectional view of a tuneable known grating coupled sampled reflector (GCSR) laser;
- Figure 3 illustrates a first embodiment of an inventive laser;
- Figure 4 is a block diagram illustrating a control circuit;
- Figure 5 illustrates diagrammatically the laser output power as a function of the current through the coupler section;
- Figure 6 is a diagrammatic illustration of the laser output power as a function of transmitted wavelength; and
- Figure 7 illustrates a second embodiment of an inventive laser.

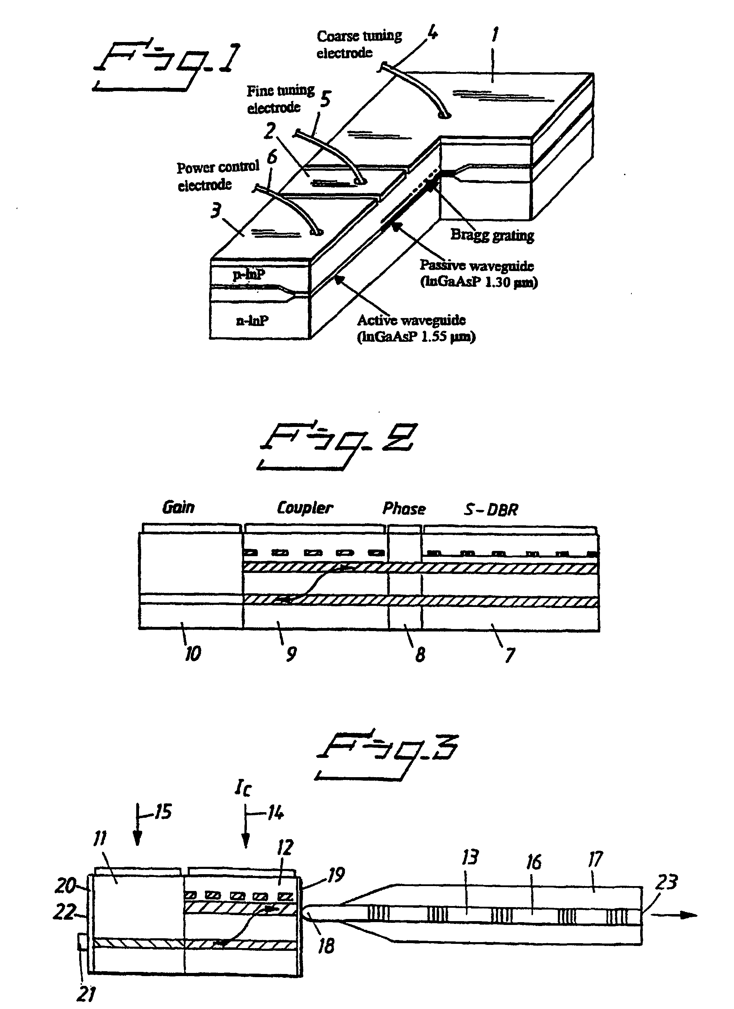

Figure 1 illustrates a DBR laser that includes three sections, these being a Bragg reflector 1, a phase section 2 and a gain section 3. Each section is activated by injecting current thereinto via a respective electric conductor 4, 5, 6.

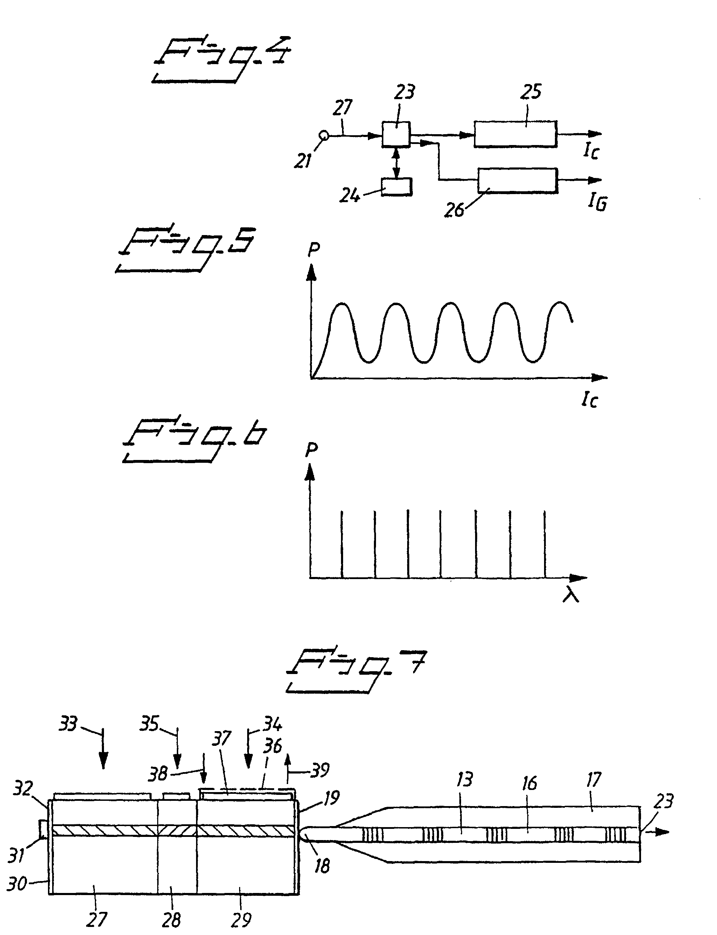

Figure 2 is a sectional view of a tuneable grating coupled sampled reflector (GCSR) laser. A laser of this kind has four sections, these being a Bragg reflector 7, a phase section 8, a coupler 9 and a gain section 10. Each of the sections is activated by injecting current into respective sections.

When the tuning currents, i.e. the currents injected into the different sections, are changed, the wavelength of the laser, the side mode suppression and the optical power of the laser will also be changed. In particular, the voltage across the active laser section will depend on whether or not the laser finds itself at a good operating point or close to a mode jump.

The laser will operate in accordance with a given mode and will give rise to different generated powers and different wavelengths with different tuning current combinations, For instance, if the Bragg current, i.e. the tuning current through the Bragg section, is swept, the laser will pass through a series of mode jumps. The wavelength changes incrementally with each of these mode jumps. Side mode suppression is good between the mode jumps and poor at a mode jump. Thus, the laser shall be caused to have an operating point which lies far away from a mode jump.

Figures 3 and 7 illustrate respectively two different tuneable lasers according to the invention. The invention is not limited to these laser designs, but can also be applied with lasers of other types.

The laser shown in Figure 3 includes a gain section 11 and a coupler section 12 of the kind found with a GCSR laser.

The laser according to Figure 7 includes a reflector 27 that has a modulated Bragg grating, a phase section 28 and a gain section 29, in other words this part of the laser is of the type shown in Figure 1.

Both lasers thus include a gain section 11; 29 and a tuneable wavelength-selective filter 12; 27.

According to the invention, there is provided a reflection filter in the form of an external reflector 13 which is adapted to give a number of fixed reflection maxima, where each maximum corresponds to a given wavelength, said reflection filter being adapted to coact with said tuneable filter. The laser is adapted to be tuned to lase at any one of said wavelengths, by tuning the tuneable filter.

According to a first preferred embodiment of the invention, the tuneable filter is comprised of a coupler section 12 to which the gain section 11 is connected and to which the external reflector 13 is connected on the opposite side thereof. This embodiment is shown in Figure 3.

The laser according to Figure 3 is adapted to be tuned to lase at any one of said wavelengths, by varying the current I through the coupler section 12. The current injected is illustrated by the arrow 14. The arrow 15 illustrates the current injected into the gain section 11.

According to a second preferred embodiment of the invention, shown in Figure 7, the tuneable filter is comprised of a modulated Bragg reflector 27, where a gain section 29 is located between the Bragg reflector and said external reflector 13.

The laser according to Figure 7 is adapted to be tuned to lase at any selected one of said wavelengths, by varying the current I through the reflector 27. The current injected is illustrated with the arrow 33, while the arrow 34 illustrates the current injected into the gain section 29 and the arrow 35 illustrates the current through the phase section 28.

The tuneable filter 12; 27 and said gain section 11; 29 will preferably be comprised of semiconductor material.

The tuneable filter 12; 27 and said gain section 11; 29 will also preferably be implemented in a monolithic component.

According to one preferred embodiment, the tuneable filter 12; 27 is adapted to be tuned by varying the current through the tuneable filter.

According to an alternative and also preferred embodiment, the tuneable filter 12; 27 is adapted to be tuned by varying the temperature of the filter.

The external reflector 13 will preferably include a modulated Bragg grating.

Furthermore the external reflector 13 will preferably comprise a dielectric light waveguide 16 provided with a modulated Bragg grating.

In this respect, it is particularly preferred that said light waveguide is comprised of fibreglass 16 formed into a lens 18, or has a narrowing part at that end connected to the laser.

The fibreglass core is coated with a cladding layer 17.

The fibre 16 is treated conventionally to reduce reflections.

The surface of the coupler section 12 that faces towards the fibre 16 has applied thereon a layer 19 of anti-reflection agent. A highly reflective layer 20 is provided on the free end surface of the gain section.

As a result of the described laser designs, the lasers will only be able to lase at those reflection peaks that are determined by the external reflector with fixed reflection peaks.

Such an external grating can be produced with a precision that is so high that the laser will lase at a given wavelength with very high precision, such as a precision of +/-1 GHz.

With respect to communication lasers, the grating is suitably constructed to enable the laser to lase at all of the frequency channels used by the communication system concerned. The number of channels used is normally from 8 to 32.

According to one embodiment of the present invention, the channel desired, i.e. the desired frequency, as mentioned above, is set by adjusting the current through the tuneable filter, which is the coupler section in the Figure 3 embodiment and the reflector 27 in the Figure 7 embodiment.

According to the aforesaid alternative embodiment, a desired channel is set by varying the temperature of the tuneable filter 12; 27. This is effected in a known manner, by coating the upper side of the filter with an electrically conductive material 36, as illustrated in broken lines in Figure 7, instead of an electrode 37 for injecting current into the filter as in the case of current control. Current is sent into one end of the layer 36 and taken out at the other end, as indicated by the arrows 38, 39. The heat generated in the layer 36 and therewith the temperature of the filter is varied by varying the current conducted through the layer. Naturally, a corresponding temperature regulation can be effected in the coupler section of the Figure 3 embodiment.

Thus, the invention provides a laser that has the advantages of tuneable lasers, namely frequency setting by current control, without the drawbacks of such lasers with regard to frequency accuracy, combined with the advantages of single-mode lasers with respect to high frequency precision.

According to one highly preferred embodiment of the invention, a monitor diode 21 which functions to measure the laser output power is placed at the rear side of the laser, i.e. at the free end-surface 22. The laser light is led out from the laser at the free end 23 of the external reflector.

Figure 4 is a schematic block diagram illustrating a control means forming part of the invention. The reference numeral 23 identifies a microprocessor with an associated memory 24. The memory is a random access memory (RAM). The microprocessor is of some suitable known kind. Some other suitable circuit may be used instead of a microprocessor, such as an application specific integrated circuit (ASIC). The microprocessor is adapted to activate the sections 11, 12; 27, 28, 29 individually with respect to injected current, via conventional current generators 25, 26 connected to respective sections. The monitor diode 21 is of a conventional kind. The monitor diode is adapted to measure laser transmission power and to deliver to the microprocessor 25 a signal which is relative to the transmission power, via a conductor 27.

According to one embodiment, activation of the laser coupler section is measured as the current that passes through the section. This measuring procedure is effected with conventional means.

According to an alternative embodiment, activation of the laser coupler section is measured on the basis of the voltage that prevails across the sections. This measuring process is effected with the aid of conventional means.

Figure 5 is a schematic diagrammat of the laser output power (P) as a function of the current (I_{c}) through the coupler section 12. It will be seen that the power varies periodically, where each maximum corresponds to a wavelength at which the laser lases. Correspondingly, the output power varies with the current through the filter 27 in the case of the laser constructed in accordance with Figure 7.

Figure 6 is a diagram which shows that the output power of the laser is high solely at a number of well-defined wavelengths. Because the laser solely lases at very well-defined wavelengths, the output power is spiked in Figure 6, where each spike has a width of, e.g., +/-1 GHz. The different wavelengths at which the laser lases can be detected very easily by means of the monitor diode.

The present invention also relates to a method of tuning a laser of the aforedescribed kind according to claim 12.

According to the inventive method, a laser that includes a gain section and a tuneable wavelength-selective filter is tuned by causing a reflection filter which has the form of an external reflector 13 and which is adapted to give a plurality of fixed reflection maxima, where each maximum corresponds to a given wavelength, to coact with said tuneable filter, and by tuning the laser by current control to lase at any one of said wavelengths by tuning the tuneable filter.

According to a first preferred method, a monitor diode 21 is adapted to measure the laser output power, where the current through the tuneable filter 12; 27 or the voltage across said tuneable filter is caused to increase successively from zero as the laser output power is measured by the monitor diode 21, wherewith the output power passes through a number of maxima, each of which corresponds to a given wavelength, and where the current passing through the tuneable filter or the voltage across said filter is set so that the laser will lase at any one of said wavelengths.

According to a second, alternative preferred method, a monitor diode 21 is adapted to measure the laser output power, wherein the temperature of the tuneable filter 12; 27 is caused to increase successively from a predetermined start temperature as the laser output power is measured by means of the monitor diode 21, and wherein the temperature of the tuneable filter is set so that the laser will lase at any one of said wavelengths.

According to a first embodiment of the method, the output signal of the monitor diode is stored in the microprocessor and also the current through the coupler section, or the voltage across said coupler section, at each output power maximum is stored in said microprocessor together with the ordinal number of the maximum concerned.

The laser can then be readily adjusted to lase at a given wavelength corresponding to a given ordinal number, by causing the microprocessor to activate the current generator 25 with a current that causes the laser to lase at a desired wavelength from those wavelengths that are available.

According to one preferred embodiment, the output signal of the monitor diode 21 is stored in a microprocessor or corresponding device, wherein the current through the tuneable filter 12; 27, the voltage across the tuneable filter or the temperature of the tuneable filter at each output power maximum are stored together with the ordinal number of the maximum concerned.

According to a further preferred embodiment, the number of through-passed output power maxima is counted whilst the current through the tuneable filter 12; 27, the voltage across the tuneable filter or the temperature of the tuneable filter is/are caused to increase successively. Tuning of the filter is stopped, when the ordinal number of a predetermined maximum is reached.

According to one advantageous embodiment, the operating point of the laser can be finely optimised automatically, by applying a modulation signal to the tuneable filter.

The power measured via the monitor detector varies with the current across the tuneable filter and will have an extreme value when the power measured is optimal. By multiplying the coupler current modulation by the measured power, there is obtained a signal which indicates the direction in which the current shall flow through the coupler section.

The invention has been described above with reference to a number of exemplifying embodiments. It will be understood, however, that the laser can be modified without departing from the concept of combining a tuneable wavelength-selective filter with an external reflector so as to obtain a laser that has a plurality of fixed lasing frequencies.

The present invention shall not therefore be considered to be limited to the aforedescribed embodiments, since variations and modifications can be made within the scope of the following Claims.

## Claims

1. A tuneable laser that includes a gain section (11; 34), a tuneable wavelength-selective filter (12; 27), and a reflection filter, **characterised in that** said reflection filter is in the form of an external reflector (13) adapted to give a plurality of fixed reflection maxima, where each maximum corresponds to a given wavelength, said reflection filter being adapted to coact with said tuneable filter; and **in that** the laser can be tuned by current control to lase at any one of said wavelengths, by tuning the tuneable filter (12; 27).

2. A tuneable laser according to Claim 1, **characterised in that** the tuneable filter (12; 27) and the gain section (12; 34) are comprised of semiconductor material.

3. A tuneable laser according to Claim 2, **characterised in that** the tuneable filter (12; 27) and the gain section (12; 34) are implemented in a monolithic component.

4. A tuneable laser according to Claim 1, 2 or 3, **characterised in that** the tuneable filter (12; 27) is adapted to be tuned by varying the current through the tuneable filter.

5. A tuneable laser according to Claim 1, 2 or 3, **characterised in that** the tuneable filter (12; 27) is adapted to be tuned by varying the temperature of the filter.

6. A tuneable laser according to Claim 1, 2, 3, 4 or 5, **characterised in that** the external reflector (13) includes a modulated Bragg grating.

7. A tuneable laser according to Claim 1, 2, 3, 4, 5 or 6, **characterised in that** the tuneable filter is comprised of a coupler section (12) to which the gain section (11) is connected and to the opposite side of which the external reflector (13) is connected.

8. A tuneable laser according to Claim 1, 2, 3, 4, 5 or 6, **characterised in that** the tuneable filter is comprised of a modulated Bragg reflector (27), wherein a gain section (29) is located between the Bragg reflector and said external reflector (13).

9. A tuneable laser according to Claim 1, 2, 3, 4, 5, 6, 7 or 8, **characterised in that** the external reflector (13) is comprised of a dielectric light waveguide (16) that includes a modulated Bragg grating.

10. A tuneable laser according to Claim 9, **characterised in that** said light waveguide is a fibreglass structure (16) in the form of a lens (18) or has a tapering part at the end connected to said laser.

11. A tuneable laser according to any one of the preceding Claims, **characterised by** a monitor diode (21) which is adapted to measure the laser output power and which is placed at the rear side (22) of said laser, i.e. on the side opposite to that to which the external reflector (13) is connected.

12. A method of tuning a laser that includes a gain section (11), a tuneable wavelength-selective filter (12; 27), and a reflection filter, **characterised in that** said reflection filter is in the form of an external reflector (13) and adapted to give a plurality of fixed reflection maxima where each maximum corresponds to a given wavelength, to coact with said tuneable filter (12; 27); and by causing the laser to be tuned by current control to lase at any of said wavelengths, by tuning the tuneable filter.

13. A method according to Claim 12, **characterised by** causing a monitor diode (21) to measure the laser output power; successively increasing the current through the tuneable filter (12; 27) or the voltage across said tuneable filter from zero whilst measuring the laser output power by means of said monitor diode (21), wherewith the output power passes through a number of maxima where each maximum corresponds to a given wavelength; and by adjusting the current through the tuneable filter or the voltage across said tuneable filter so that the laser will lase at any one of said wavelengths.

14. A method according to Claim 12, **characterised by** causing a monitor diode (21) to measure the laser output power; successively increasing the temperature through the tuneable filter (12; 27) from a predetermined start temperature whilst the monitor diode (21) measures the laser output power; and adjusting the temperature of the tuneable filter so that the laser will lase at any one of said wavelengths.

15. A method according to Claim 13 or 14, **characterised by** storing the output signal of the monitor diode (21) in a microprocessor or corresponding device; and by storing the value of the current through the tuneable filter (12; 27), the value of the voltage across the tuneable filter or the temperature of said tuneable filter at each output power maximum together with the ordinal number of the maximum concerned.

16. A method according to Claim 15, **characterised by** counting the number of through-passed maxima whilst successively increasing the current through the tuneable filter (12; 27), the voltage across the tuneable filter or the temperature of said tuneable filter; and terminating tuning of said filter when the ordinal number of a predetermined maximum has been reached.

## Patentansprüche

1. Abstimmbarer Laser, der einen Verstärkungsbereich (11; 34), einen abstimmbaren wellenlängenselektiven Filter (12; 27) sowie einen Reflexionsfilter aufweist, **dadurch gekennzeichnet, daß** der Reflexionsfilter in der Form eines externen Reflektors (13) vorliegt, der dafür ausgelegt ist, eine Vielzahl fester Reflexionsmaxima zu ergeben, wobei jedes Maximum einer vorgegebenen Wellenlänge entspricht, wobei der Reflexionsfilter dafür ausgelegt ist, mit dem abstimmbaren Filter zusammenzuwirken; und daß der Laser durch eine Stromsteuerung abgestimmt werden kann, um bei irgendeiner der Wellenlängen zu lasern, indem der abstimmbare Filter (12; 27) abgestimmt wird.

2. Abstimmbarer Laser nach Anspruch 1, **dadurch gekennzeichnet, daß** der abstimmbare Filter (12; 27) und der Verstärkungsbereich (12; 34) aus Halbleitermaterial bestehen.

3. Abstimmbarer Laser nach Anspruch 2, **dadurch gekennzeichnet, daß** der abstimmbare Filter (12; 27) und der Verstärkungsbereich (12; 34) in einer monolithischen Komponente implementiert sind.

4. Abstimmbarer Laser nach Anspruch 1, 2 oder 3, **dadurch gekennzeichnet, daß** der abstimmbare Filter (12; 27) so ausgelegt ist, daß er abgestimmt wird, indem der Strom durch den abstimmbaren Filter verändert wird.

5. Abstimmbarer Laser nach Anspruch 1, 2 oder 3, **dadurch gekennzeichnet, daß** der abstimmbare Filter (12; 27) so ausgelegt ist, daß er abgestimmt wird, indem die Temperatur des Filters verändert wird.

6. Abstimmbarer Laser nach Anspruch 1, 2, 3, 4 oder 5, **dadurch gekennzeichnet, daß** der externe Reflektor (13) ein moduliertes Bragg-Gitter aufweist.

7. Abstimmbarer Laser nach Anspruch 1, 2, 3, 4, 5 oder 6, **dadurch gekennzeichnet, daß** der abstimmbare Filter einen Kopplerbereich (12) aufweist, mit dem der Verstärkungsbereich (11) verbunden ist und mit dessen gegenüberliegender Seite der externe Reflektor (13) verbunden ist.

8. Abstimmbarer Laser nach Anspruch 1, 2, 3, 4, 5 oder 6, **dadurch gekennzeichnet, daß** der abstimmbare Filter einen modulierten Bragg-Reflektor (27) aufweist, wobei ein Verstärkungsbereich (29) zwischen dem Bragg-Reflektor und dem externen Reflektor (13) angeordnet ist.

9. Abstimmbarer Laser nach Anspruch 1, 2, 3, 4, 5, 6, 7 oder 8, **dadurch gekennzeichnet, daß** der externe Reflektor (13) einen dielektrischen Lichtwellenleiter (16) aufweist, der ein moduliertes Bragg-Gitter aufweist.

10. Abstimmbarer Laser nach Anspruch 9, **dadurch gekennzeichnet, daß** der Lichtwellenleiter eine Glasfaserstruktur (16) in der Form einer Linse (18) ist oder einen sich verjüngenden Abschnitt an dem mit dem Laser verbundenen Ende hat.

11. Abstimmbarer Laser nach einem der vorhergehenden Ansprüche, **gekennzeichnet durch** eine Überwachungsdiode (21), die dafür ausgelegt ist, die Laserausgangsleistung zu messen und die an der Rückseite (22) des Lasers angeordnet ist, d.h. an der Seite, die derjenigen gegenüberliegt, mit der der externe Reflektor (13) verbunden ist.

12. Verfahren zum Abstimmen eines Lasers, der einen Verstärkungsbereich (11), einen abstimmbaren wellenlängenselektiven Filter (12; 27) und einen Reflexionsfilter aufweist, **dadurch gekennzeichnet, daß** der Reflexionsfilter in der Form eines externen Reflektors (13) vorliegt und dafür ausgelegt ist, eine Vielzahl fester Reflexionsmaxima zu ergeben, wobei jedes Maximum einer vorgegebenen Wellenlänge entspricht, um mit dem abstimmbaren Filter (12; 27) zusammenzuwirken; und indem der Laser veranlasst wird, durch eine Stromsteuerung abgestimmt zu werden, um bei irgendeiner der Wellenlängen zu lasern, indem der abstimmbare Filter abgestimmt wird.

13. Verfahren nach Anspruch 12, **gekennzeichnet durch** ein Veranlassen einer Überwachungsdiode (21), die Laserausgangsleistung zu messen; ein sukzessives Erhöhen des Stroms **durch** den abstimmbaren Filter (12; 27) oder der Spannung über den abstimmbaren Filter von Null ausgehend, während die Laserausgangsleistung mittels der Überwachungsdiode (21) gemessen wird, womit die Ausgangsleistung mehrere Maxima durchläuft, wobei jedes Maximum einer vorgegebenen Wellenlänge entspricht; und **durch** ein Einstellen des Stroms **durch** den abstimmbaren Filter oder der Spannung über den abstimmbaren Filter so, daß der Laser bei irgendeiner der Wellenlängen lasert.

14. Verfahren nach Anspruch 12, **gekennzeichnet durch** ein Veranlassen einer Überwachungsdiode (21), die Laserausgangsleistung zu messen; ein sukzessives Erhöhen der Temperatur **durch** den abstimmbaren Filter (12; 27) von einer vorgegebenen Starttemperatur ausgehend, während die Überwachungsdiode (21) die Laserausgangsleistung mißt; und ein Einstellen der Temperatur des abstimmbaren Filters so, daß der Laser bei irgendeiner der Wellenlängen lasert.

15. Verfahren nach Anspruch 13 oder 14, **gekennzeichnet durch** ein Speichern des Ausgangssignals der Überwachungsdiode (21) in einem Mikroprozessor oder einer entsprechenden Einrichtung; und **durch** ein Speichern des Wertes des Stroms **durch** den abstimmbaren Filter (12; 27), des Wertes der Spannung über den abstimmbaren Filter oder der Temperatur des abstimmbaren Filters bei jedem Ausgangsleistungsmaximum zusammen mit der Ordnungszahl des betroffenen Maximums.

16. Verfahren nach Anspruch 15, **gekennzeichnet durch** ein Zählen der Zahl der durchlaufenen Maxima, während sukzessive der Strom **durch** den abstimmbaren Filter (12; 27), die Spannung über den abstimmbaren Filter oder die Temperatur des abstimmbaren Filters erhöht werden; und **durch** ein Beenden des Abstimmens des Filters, wenn die Ordnungszahl eines vorbestimmten Maximums erreicht worden ist.

## Revendications

1. Laser accordable comprenant une section de gain (11 ; 34), un filtre accordable sélectif en longueur d'onde (12 ; 27), et un filtre à réflexion,
**caractérisé en ce que**
le filtre à réflexion se présente sous la forme d'un réflecteur extérieur (13) conçu pour donner un certain nombre de maxima de réflexion fixes dans lesquels chaque maximum correspond à une longueur d'onde donnée, ce filtre à réflexion étant destiné à coopérer avec le filtre accordable ; et
le laser peut être accordé par une commande de courant pour laser à l'une quelconque des longueurs d'onde ci-dessus, par accord du filtre accordable (12 ; 27).

2. Laser accordable selon la revendication 1,
**caractérisé en ce que**
le filtre accordable (12 ; 27) et la section de gain (11 ; 34) sont constitués d'un matériau semi-conducteur.

3. Laser accordable selon la revendication 2,
**caractérisé en ce que**
le filtre accordable (12 ; 27) et la section de gain (11; 34) sont mis en oeuvre dans un composant monolithique.

4. Laser accordable selon la revendication 1, 2 ou 3,
**caractérisé en ce que**
le filtre accordable (12 ; 27) est conçu pour être accordé par variation du courant qui le traverse.

5. Laser accordable selon la revendication 1, 2 ou 3,
**caractérisé en ce que**
le filtre accordable (12 ; 27) est conçu pour être accordé par variation de la température du filtre.

6. Laser accordable selon la revendication 1, 2, 3, 4 ou 5,
**caractérisé en ce que**
le réflecteur extérieur (13) comprend un réseau de Bragg modulé.

7. Laser accordable selon la revendication 1, 2, 3, 4, 5 ou 6,
**caractérisé en ce que**
le filtre accordable est constitué d'une section de coupleur (12) à laquelle est couplée la section de gain (11), tandis que le réflecteur extérieur (13) est connecté à son côté opposé.

8. Laser accordable selon la revendication 1, 2, 3, 4, 5 ou 6,
**caractérisé en ce que**
le filtre accordable est constitué d'un réflecteur de Bragg modulé (27), tandis qu'une section de gain (29) est placée entre le réflecteur de Bragg et le réflecteur extérieur (13).

9. Laser accordable selon la revendication 1, 2, 3 ,4, 5, 6, 7 ou 8,
**caractérisé en ce que**
le réflecteur extérieur (13) est constitué d'un guide d'ondes de lumière diélectrique (16) qui comprend un réseau de Bragg modulé.

10. Laser accordable selon la revendication 9,
**caractérisé en ce que**
le guide d'ondes de lumière est une structure à fibre de verre (16) se présentant sous la forme d'une lentille (18), ou comporte une partie conique allant en s'amincissant à l'extrémité qui est connectée au laser.

11. Laser accordable selon l'une quelconque des revendications précédentes,
**caractérisé par**
une diode de moniteur (21) qui est destinée à mesurer la puissance de sortie du laser et qui est placée du côté arrière (22) de ce laser, c'est à dire du côté opposé à celui auquel est connecté le réflecteur extérieur (13).

12. Procédé d'accord d'un laser comprenant une section de gain (11), un filtre accordable sélectif en longueur d'onde (12 ; 27), et un filtre à réflexion,
**caractérisé en ce que**
le filtre à réflexion se présente sous la forme d'un réflecteur extérieur (13) et sert à donner un certain nombre de maxima de réflexion fixes dans lesquels chaque maximum correspond à une longueur d'onde donnée, de manière à coopérer avec le filtre accordable (12 ; 27) ; et
on accorde le laser par une commande de courant de façon qu'il lase à l'une quelconque des longueurs d'onde ci-dessus, par accord du filtre accordable.

13. Procédé selon la revendication 12,
**caractérisé par** les étapes consistant à amener une diode de moniteur (21) à mesurer la puissance de sortie du laser ;
augmenter successivement le courant passant dans le filtre accordable (12 ; 27) ou la tension aux bornes de ce filtre accordable, à partir de zéro, tout en mesurant la puissance de sortie du laser au moyen de la diode de moniteur (21), de façon que la puissance de sortie passe par un certain nombre de maxima dans lesquels chaque maximum correspond à une longueur d'onde donnée ; et
régler le courant passant dans le filtre accordable ou la tension aux bornes de ce filtre accordable, de façon que le laser lase à l'une quelconque des longueurs d'onde ci-dessus.

14. Procédé selon la revendication 12,
**caractérisé par** les étapes consistant à
amener une diode de moniteur (21) à mesurer la puissance de sortie du laser ;
augmenter successivement la température à travers le filtre accordable (12 ; 27) à partir d'une température de départ prédéterminée, tandis que la diode de moniteur (21) mesure la puissance de sortie du laser ; et
régler la température du filtre accordable de façon que le laser lase à l'une quelconque des longueurs d'onde ci-dessus.

15. Procédé selon la revendication 13 ou 14,
**caractérisé par** les étapes consistant à
stocker le signal de sortie de la diode de moniteur (21) dans un microprocesseur ou autre dispositif correspondant et
stocker la valeur du courant passant dans le filtre accordable (12 ; 27), la valeur de la tension aux bornes de ce filtre accordable ou la température de celui-ci, à chaque maximum de puissance de sortie, en même temps que le nombre ordinal du maximum concerné.

16. Procédé selon la revendication 15,
**caractérisé par** les étapes consistant à
compter le nombre de maxima par lesquels on passe, tout en augmentant successivement le courant à travers le filtre accordable (12 ; 27), la tension aux bornes de ce filtre accordable ou la température de celui-ci ; et
terminer l'accord du filtre lorsque le nombre ordinal d'un maximum prédéterminé a été atteint.
